# EUROPEAN PATENT SPECIFICATION

(11) **EP 0 442 303 B1**
(45) Date of publication and mention of the grant of the patent: **06.12.1995**
(21) Application number: 91100953.8
(22) Date of filing: 25.01.1991
(51) Int. Cl.: C23C 16/26

(54) **CVD Diamond workpieces and their fabrication**
CVD-Diamantwerkstücke und ihre Herstellung
Pièces en diamant obtenu par déposition chimique en phase vapeur et leur fabrication

(30) Priority: 13.02.1990 US 479329
(43) Date of publication of application: 21.08.1991
(73) Proprietor: GENERAL ELECTRIC COMPANY, Schenectady New York 12305 (US)
(72) Inventor: DeVries, Robert Charles, Burnt Hills, NY 12027 (US); Anthony, Thomas Richard, Schenectady, NY 12309 (US); Fleischer, James Fulton, Scotia, NY 12303 (US)
(74) Representative: Pratt, Richard Wilson

(56) References cited:
- EP-A- 0 319 926
- EP-A- 0 400 947
- PATENT ABSTRACTS OF JAPAN, vol. 13, no. 388 (C-630), 28 August 1989
- PATENT ABSTRACTS OF JAPAN, vol. 13, no. 65 (M-797), 14 February 1989
- PATENT ABSTRACTS OF JAPAN, vol. 13, no. 366 (E-806), 15 August 1989
- APPLIED PHYSICS LETTERS, vol. 46, no. 2, January 1985, American Institute of Physics, New York, NY (US); A. SAWABE et al., pp. 146-147
- APPLIED PHYSICS LETTERS, vol. 55, no. 25, 18 December 1989, American Institute of Physics, New York, NY (US); M. YOSHIKAWA et al., pp. 2608-2610

## Description

### Background of the Invention

The present invention relates to diamond workpieces and more particularly to their fabrication based on chemical vapor deposition technology.

Its hardness and thermal properties are but two of the characteristics that make diamond useful in a variety of industrial components. Initially, natural diamond was used in a variety of abrasive applications. With the ability to synthesize diamond by high pressure/high temperature (HP/HT) techniques utilizing a catalyst/sintering aid under conditions where diamond is the thermally stable carbon phase, a variety of additional products found favor in the marketplace. Polycrystalline diamond compacts, often supported on a tungsten carbide support in cylindrical or annular form, extended the product line for diamond additionally. However, the requirement of high pressure and high temperature has been a limitation in product configuration, for example.

Recently, industrial effort directed toward the growth of diamond at low pressures, where it is metastable, has increased dramatically. Although the ability to produce diamond by low-pressure synthesis techniques has been known for decades, drawbacks including extremely low growth rates prevented wide commercial acceptance. Recent developments have led to higher growth rates, thus spurring recent industrial interest in the field. Additionally, the discovery of an entirely new class of solids, known as "diamond like" carbons and hydrocarbons, is an outgrowth of such recent work.

Low pressure growth of diamond has been dubbed "chemical vapor deposition" or "CVD" in the field. Two predominant CVD techniques have found favor in the literature. One of these techiques involves the use of a dilute mixture of hydrocarbon gas (typically methane) and hydrogen wherein the hydrocarbon content usually is varied from about 0.1% to 2.5% of the total volumetric flow. The gas is introduced via a quartz tube located just above a hot tungsten filament which is electrically heated to a temperature ranging from between about 1750° to 2400°C. The gas mixture disassociates at the filament surface and diamonds are condensed onto a heated substrate placed just below the hot tungsten filament. The substrate is held in a resistance heated boat (often molybdenum) and heated to a temperature in the region of about 500° to 1100°C.

The second technique involves the imposition of a plasma discharge to the foregoing filament process. The plasma discharge serves to increase the nucleation density, growth rate, and it is believed to enhance formation of diamond films as opposed to discrete diamond particles. Of the plasma systems that have been utilized in this area, there are three basic systems. One is a microwave plasma system, the second is an RF (inductively or capacitively coupled) plasma system, and the third is a d.c. plasma system. The RF and microwave plasma systems utilize relatively complex and expensive equipment which usually requires complex tuning or matching networks to electrically couple electrical energy to the generated plasma. Additionally, the diamond growth rate offered by these two systems can be quite modest.

Heretofore, CVD diamond has been coated onto tungsten carbide or other substrates to make cutting tool inserts (U.S. Pats. Nos. 4,707,384 and 4,731,296) or co-deposited with boron or another element for making semiconductors (e.g. EP Publications Nos. 286,306 and 282,054).

JP-A-1138110 discloses the manufacture of a diamond pipe by providing a CVD diamond film on the surface of a columnar base material and subsequently removing the base material.

JP-A-63267166 discloses forming a thin film structure such as a diamond layer by forming a thin film of diamond on a base body having the same surface shape as that desired for the diamond film, by means of vacuum evaporation and subsequently removing the base.

JP-A-1123422 discloses forming a pattern of diamond film on a substrate by forming a negative pattern film on the substrate, growing a diamond film on the negative pattern film, and removing both the negative pattern film and the diamond film on the negative pattern film, to leave the desired diamond pattern film on the substrate.

EP-A-0319926 discloses a method for the preparation of a diamond-clad machining tool comprising the steps of (a) forming a film of diamond of 10 to 100 »m thickness by the vapor-phase deposition on the surface of a temporary substrate of e.g. silicon (b) bonding the diamond film as borne by the temporary substrate to the surface of a base body of the tool by brasing and (c) removing the temporary substrate e.g. by grinding, to leave the diamond film bonded to the base body of the tool by brazing.

EP-A-0400947 discloses a method of producing a diamond or diamond-like film having a desired profile which involves providing a solid carbon substrate having a surface shaped to the desired profile, creating a thin carbide layer on the profiled surface growing a diamond or diamond-like film on the carbide layer removing the carbon substrate and optionally also removing the carbide layer.

The present invention takes advantage of the fact that CVD diamond coatings can be deposited on complicated surface shapes relatively readily. Moreover, the diamond surface adjacent the substrate upon which the CVD diamond layer is deposited has been found to exhibit the surface qualities of the surface of the substrate upon which such layer was deposited. Both of these, as well as other discoveries make it possible to fabricate three-dimensional diamond workpieces for a variety of applications. Accordingly, the present invention provides a method for making a three-dimensional diamond workpiece which consists of :
(a) placing in a chamber a multi-planar pattern heated to a CVD diamond-forming temperature of from 500 to 1100°C, said pattern being the negative of said workpiece;
(b) providing a hydrocarbon/hydrogen gaseous mixture within said chamber at a pressure of from 0.13 to 1334 mbar (0.01 to 1000 Torr);
(c) at least partially decomposing said gaseous mixture in said chamber to form a CVD diamond layer on more than one surface of said multi-planar pattern; and
(d) removing said pattern from said CVD diamond layer to form said diamond workpiece which possesses the surface characteristics of the surface of the pattern upon which it was formed.

Advantages of the present invention include the ability to custom fabricate diamond workpieces. Another advantage is the ability to fabricate such custom workpieces reproduceably. A further advantage is the ability to fabricate workpieces that exhibit a desired surface characteristic, be it smooth, textured, or the like. These and other advantages will be readily apparent to those skilled in the art based upon the disclosure contained herein.

### Brief Description of the Drawings

Figs. 1-3 depict in simplified form the method for making a convergent, flat, and divergent optical element or mirrors;
Fig. 4 depicts in simplified form the method for making a diamond nozzle workpiece;
Fig. 5 shows a cross-section and plan view of a pattern at A and B with the resultant cross-section of the diamond workpiece shown at C; and
Fig. 6 shows the cross-section of a diamond workpiece exhibiting complex re-entrant configuration.

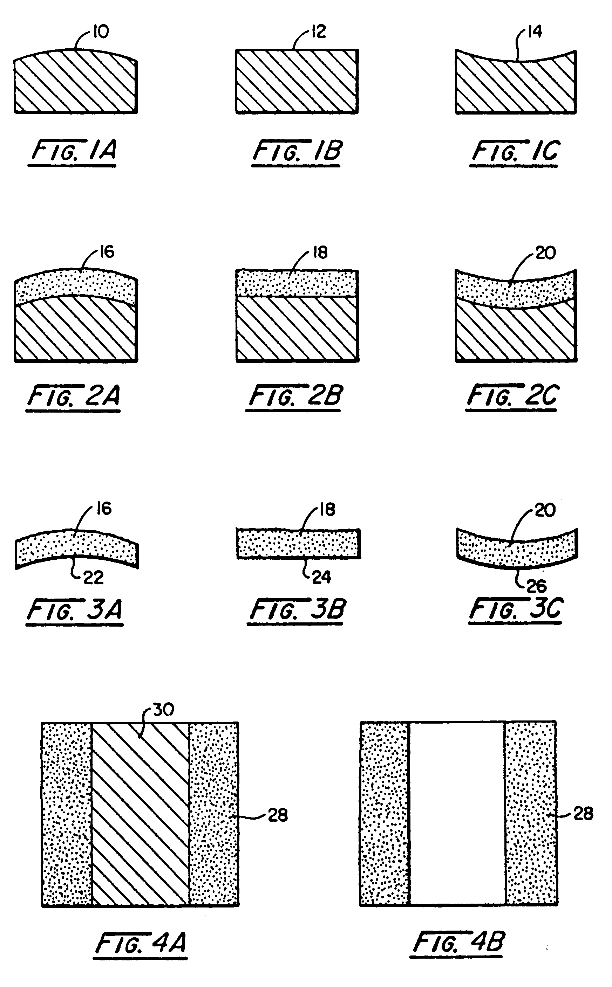

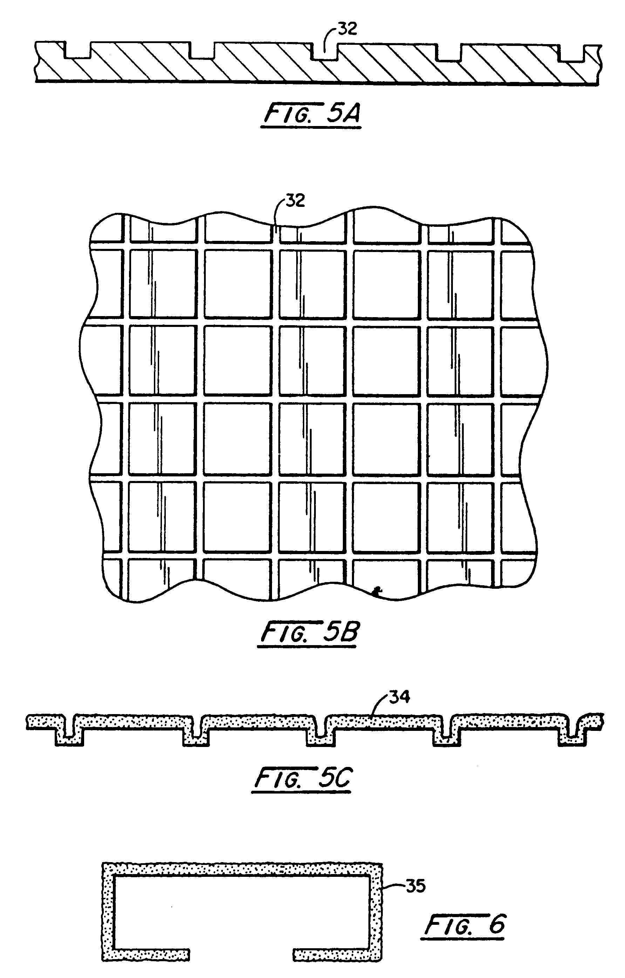

The drawings will be described in detail in connection with the description that follows. Figures 5 and 6 illustrate the invention. Figures 1-4 are for comparative purposes only.

### Detailed Description of the Invention

Conventional high pressure/high temperature techniques utilized in the production of diamond crystals and polycrystalline diamond compacts necessarily are limited to configurations compatible with necessary high pressure utilized in their formation. Accordingly, cylindrical polycrystalline diamond compacts typically are produced and then machined (e.g. electrical discharge machining or the like) to an intermediate or final product configuration. Complex product shapes are difficult to produce by such techniques. Chemical vapor deposition techniques, however, are not so-limited since the diamond is grown/deposited from a gaseous mixture directly onto a heated substrate. The heated substrate or pattern for present purposes is multiplanar and the gaseous mixture can be directed onto the entire pattern or just portions thereof.

Of course, deposition of CVD diamond onto complicated shapes has been proposed in the past; however, such proposals were formulating a supported diamond product. In contradistinction, the present invention employs a process analogous to conventional molding processes wherein a pattern or core is used in shaping a product, but then is removed and is not part of the final product. The pattern upon which the CVD diamond layer is deposited/grown in the present invention is removed from the CVD diamond layer, thus producing a three-dimensional diamond workpiece of desired configuration. It will be appreciated that not all of the pattern need be removed as some workpieces may require that some portion of the diamond layer be laminated or attached to the pattern upon which the layer was grown/deposited. In this respect, the diamond workpiece also could be re-supported following removal of the pattern. For example, the diamond workpiece may be inserted into a machined recess, metal may be deposited on an exposed surface of the diamond workpiece for providing a support to the workpiece or for use in attaching the workpiece, etc. With the ability to produce three-dimensional diamond workpieces, a variety of product configurations and application processing schemes now are possible and will be developed in the art.

With respect to conventional CVD processes useful in the present invention, hydrocarbon/hydrogen gaseous mixtures are fed into a CVD reactor as an initial step. Hydrocarbon sources can include the methane series gases, e.g. methane, ethane, propane; unsaturated hydrocarbons, e.g. ethylene, acetylene, cyclohexene, and benzene; and the like. Methane, however, is preferred. The molar ratio of hydrocarbon to hydrogen broadly ranges from about 1:10 to about 1:1,000 with about 1:100 being preferred. This gaseous mixture optionally may be diluted with an inert gas, e.g. argon. The gaseous mixture is at least partially decomposed thermally by one of several techniques known in the art. One of these techniques involves the use of a hot filament which normally is formed of tungsten, molybdenum, tantalum, or alloys thereof. U.S. Pat. No. 4,707,384 illustrates this process.

The gaseous mixture partial decomposition also can be conducted with the assistance of d.c. discharge or radio frequency electromagnetic radiation to generate a plasma, such as prosposed in U.S. Pats. Nos. 4,749,587, 4,767,608, and 4,830,702; and U.S. Pat. No. 4,434,188 with respect to use of microwaves. The substrate may be bombarded with electrons during the CVD deposition process in accordance with U.S. Pat. No. 4,740,263.

Regardless of the particular method used in generating the partially decomposed gaseous mixture, the substrate is maintained at an elevated CVD diamond-forming temperature which typically ranges from about 500° to 1100°C and preferably in the range of about 850° to 950°C where diamond growth is at its highest rate in order to minimize grain size. Pressures in the range of from about 0.13 to 1334 mbar (0.01 to 1000 Torr), advantageously about 0.13 to 10.4 bar (100-800 Torr), are taught in the art, with reduced pressure being preferred. Details on CVD processes additionally can be reviewed by reference to Angus, et at., "Low-Pressure, Metastable Growth of Diamond and 'Diamondlike' Phases", Science, vol. 241, pages 913-921 (August 19, 1988); and Bachmann, et al., "Diamond Thin Films", Chemical and Engineering News, pp. 24-39 (May 15, 1989).

With respect to the pattern, it will be appreciated that the materials of construction necessarily must be stable at the elevated CVD diamond-forming temperatures required by the CVD processing employed. Accordingly, appropriate materials include, for example, metals (e.g. tungsten, molybdenum, silicon, and platinum), alloys, ceramics (e.g. silicon carbide, boron nitride, aluminum nitride), glasses, and carbon (e.g. graphite). Patterns of mixed composition also may be utilized as is necessary, desirable, or convenient. The materials can be shaped to form the pattern by a variety of conventional techniques which need no further elaboration here. Suffice it to say that the surface or surfaces of the pattern upon which the CVD diamond layer is to be grown/deposited will have a configuration that is the negative of the desired workpiece. The thickness of the CVD diamond layer laid down can be uniform or selected areas can be made thicker than others by techniques well known in the art. Thicknesses as thin as 1 micrometer on up to 2000 micrometers or more can be laid down, depending on processing conditions and most importantly upon time. Thicknesses for a self-supporting structure are required, though such thicknesses need not be self-supporting in use as a backing or support can be attached to the diamond workpieces as noted above.

Once the desired thickness of CVD diamond has been grown/deposited on the pattern, the process is terminated and the part removed from the chamber. The pattern to be removed can be etched or dissolved, removed by grinding or like abrading techniques, or by similar processes. With certain configurations and certain materials of construction for the pattern, it may be possible for the diamond layer to simply be separated by hand from the pattern by a combination of geometry and difference in coefficient of thermal expansion. As noted above, some portions of the pattern may be retained and selective removal practiced. On occasion, it may be desirable to deposit or attach a backing material to the exposed diamond layer prior to removing the pattern. These and other processing variations all are possible due to the flexibility designed into the process of the present invention.

With respect to the possiblities of workpieces that have been made in accordance with the present invention, reference is made to the drawings. Fig. 1 shows the cross-section of three different silicon patterns wherein surfaces 10, 12, and 14 have been ground, polished, and figured to optical mirror quality. Materials other than silicon may be used, as those will appreciated based upon the disclosure contained herein. At Fig. 2, CVD diamond layers 16, 18, and 20 have been grown/deposited on surfaces 10, 12, and 14, respectively. It will be seen that the upper surfaces of these CVD diamond layers exhibit a rough crystalline texture. At Fig. 3, the silicon ingots have been dissolved with an etch, e.g. "white etch" (3 wt-parts nitric acid and 1 wt-part hydrofluoric acid) to free CVD diamond layers 16, 18, and 20, thus revealing mirror surfaces 22, 24, and 26, respectively. Optical surface 22 is concave, optical surface 24 is plano, and optical surface 26 is convex. Surfaces 22, 24, and 26 mimic the quality of surfaces 10, 12, and 14, respectively. Optical element 18 has been made from a 5.08 cm (2 in) diameter silicon ingot that was 1 mm thick. Optical element 24 was 0.5 mm in thickness. Because of diamond's high melting point (3727°C) and high thermal conductivity, such diamond mirrors have figure of merit for resistance to damage by lasers that is significantly greater than the figure of merit of mirrors made from other materials.

Referring to Fig. 4, a diamond nozzle is seen to be made by the deposition of CVD diamond layer 28 on molybdenum mandrel 30. Upon etching the molybdenum, diamond nozzle 28 as shown at Fig. 4B results. As a demonstration, 150 »m (6 mils) of CVD diamond were deposited on a 4 mil molybdenum wire held at 900°C. Nitric acid was used to etch the molybdenum mandrel, thus resulting in a 0.1 mm (4 mil) diameter tube of ballas diamond with a smooth circular internal surface as shown at Fig. 4B. It will be appreciated that there is virtually no restriction of the size of the hole that can be made in creating annulus 28. For that matter, on array of apertures can be made by starting with an array of mandrels instead of just a single one as shown at Fig. 4.

Referring to Figs. 5A and 5B, a stepped or grooved pattern is shown made from molybdenum wherein the identical grooves in a regular square pattern 5 mm apart were machined into the molybdenum substrate. As representative of such grooves, groove 32 has a width of 0.76 mm (0.03 inch), is 0.33 mm (0.013 inch) deep, and is spaced 5 mm center-to-center from adjacent grooves. The thickness of the ungrooved portion of the pattern was 3.81 mm (0.15 in) in thickness. Upon removal of the molybdenum pattern, diamond workpiece 34 as shown at Fig. 5C was recovered. Sections of workpiece 34 have been brazed to carbide substrates for production of cutting tools. Based on this work, it is apparent that zig-zag, curved, and other cross-sectional shapes can be made by suitable preparation of the pattern substrate.

In another experiment, CVD diamond was deposited on a 3.175 cm (1 1/4 inch) diameter by 0.76 mm (0.03 inch) thick graphite disk after which the graphite disk was removed. CVD diamond workpiece 35 as depicted at Fig. 6 was recovered. It will be observed that one surface of the graphite disk was covered as well as the sides. Only a portion, however, of the reverse disk surface was covered with the diamond to result in a complex re-entrant diamond layer shape.

It will be appreciated that before or after the pattern is removed, metal, for example, can be deposited by CVD or other techniques onto an exposed surface of the CVD diamond workpiece for providing a backing and/or means of attachment (e.g. by brazing or the like) to another substrate material. As described above, the diamond workpieces produced according to the method of the present invention and illustrated in Figs. 5 and 6 additionally could be attached to carbide or other substrate material to form segments or tools useful in a variety of applications. Further, it will be recognized that the workpiece configurations set forth in Figs. 5 and 6 merely are illustrative of the myriad of workpieces that can be fabricated in accordance with the precepts of the present invention.

## Claims

1. A method for making a three-dimensional diamond workpiece which consists of :
(a) placing in a chamber a multi-planar pattern heated to a CVD diamond-forming temperature of from 500 to 1100°C, said pattern being the negative of said workpiece;
(b) providing a hydrocarbon/hydrogen gaseous mixture within said chamber at a pressure of from 0.13 to 1334 mbar (0.01 to 1000 Torr);
(c) at least partially decomposing said gaseous mixture in said chamber to form a CVD diamond layer on more than one surface of said multi-planar pattern; and
(d) removing said pattern from said CVD diamond layer to form said diamond workpiece which possesses the surface characteristics of the surface of the pattern upon which it was formed.

2. The method of Claim 1 wherein the molar ratio of hydrocarbon to hydrogen in said gaseous mixtures ranges from between about 1:10 and 1:1,000.

3. The method of Claim 2 wherein said gaseous mixture additionally comprises an inert gas.

4. The method of Claim 1 wherein said hydrocarbon of said gaseous mixture comprises methane.

5. The method of Claim 1 wherein said pattern is manufactured from metal, an alloy, a ceramic, or carbon.

6. The method of Claim 1 wherein said formed CVD diamond layer ranges in thickness from between about 1 and 2000 micrometers.

7. The method of Claim 1 wherein the surface of said pattern upon which said CVD diamond layer is formed has been finished to optical mirror quality.

8. The method of Claim 1 wherein said removed CVD diamond layer is attached to a support.

9. The method of Claim 8 wherein said support is a metal, an alloy, or a ceramic.

## Patentansprüche

1. Verfahren zum Herstellen eines dreidimensionalen Diamant-Werkstückes, bestehend aus:
(a) Anordnen eines multiplanaren Musters in einer Kammer, die auf eine durch chemische Dampfabscheidung Diamant bildende Temperatur von 500 bis 1.100°C erhitzt ist, wobei das Muster das Negativ des Werkstückes ist:
(b) Schaffen einer gasförmigen Mischung aus Kohlenwasserstoff und Wasserstoff innerhalb der Kammer bei einem Druck von 0,13 bis 1334 mbar (0,01-1.000 Torr);
(c) zumindest teilweises Zersetzen der gasförmigen Mischung in der Kammer zur Bildung einer Diamantschicht durch chemische Dampfabscheidung auf mehr als einer Oberfläche des multiplanaren Musters und
(d) Entfernen des Musters von der durch chemische Dampfabscheidung gebildeten Diamantschicht zur Bildung des Diamant-Werkstückes, das die Oberflächencharakteristika der Oberfläche des Musters aufweist, auf der es gebildet wurde.

2. Verfahren nach Anspruch 1, worin das molare Verhältnis von Kohlenwasserstoff zu Wasserstoff in der gasförmigen Mischung im Bereich zwischen etwa 1:10 und 1:1.000 liegt.

3. Verfahren nach Anspruch 2, worin die gasförmige Mischung zusätzlich ein Inertgas umfaßt.

4. Verfahren nach Anspruch 1, worin der Kohlenwasserstoff der gasförmigen Mischung Methan umfaßt.

5. Verfahren nach Anspruch 1, worin das Muster aus Metall, einer Legierung, einer Keramik oder Kohlenstoff hergestellt ist.

6. Verfahren nach Anspruch 1, worin die durch chemische Dampfabscheidung gebildete Diamantschicht eine Dicke im Bereich von etwa 1 bis 2.000 »m aufweist.

7. Verfahren nach Anspruch 1, worin die Oberfläche des Musters, auf der die Diamantschicht durch chemische Dampfabscheidung gebildet wird, durch Bearbeitung eine optische Spiegelqualität erhalten hat.

8. Verfahren nach Anspruch 1, worin die durch chemische Dampfabscheidung gebildete, entfernte Diamantschicht an einem Träger angebracht ist.

9. Verfahren nach Anspruch 8, worin der Träger ein Metall, eine Legierung oder eine Keramik ist.

## Revendications

1. Procédé de fabrication de pièce tridimensionnelle en diamant, consistant:
(a) à placer dans une chambre un modèle multiplan chauffé à une température de formation de diamant par CVD, comprise entre 500 et 1100°C, ledit modèle étant le négatif de ladite pièce;
(b) à introduire dans ladite chambre un mélange gazeux d'hydrocarbure/hydrogène sous une pression comprise entre 0,13 et 1334 millibars (0,01 à 1000 Torr);
(c) à décomposer au moins partiellement ledit mélange gazeux dans la dite chambre pour former une couche de diamant par CVD sur plusieurs surfaces dudit modèle multiplan; et
(d) à retirer ledit modèle de ladite couche de diamant CVD pour former ladite pièce en diamant qui possède les caractéristiques de surface de la surface du modèle sur lequel elle a été formée.

2. Procédé selon la revendication 1, dans lequel le rapport molaire de l'hydrocarbure à l'hydrogène dans lesdits mélanges gazeux est compris entre environ 1:10 et 1:1000.

3. Procédé selon la revendication 2, dans lequel ledit mélange gazeux comprend, en outre, un gaz inerte.

4. Procédé selon la revendication 1, dans lequel ledit hydrocarbure dudit mélange gazeux comprend du méthane.

5. Procédé selon la revendication 1, dans lequel ledit modèle est fabriqué à partir d'un métal, d'un alliage, d'une céramique ou du carbone.

6. Procédé selon la revendication 1, dans lequel ladite couche de diamant CVD formée a une épaisseur comprise entre environ 1 et 2000 micromètres.

7. Procédé selon la revendication 1, dans lequel la surface dudit modèle sur lequel est formée ladite couche de diamant CVD a une finition de la qualité du type miroir optique.

8. Procédé selon la revendication 1, dans lequel ladite couche de diamant CVD enlevée est fixée à un support.

9. Procédé selon la revendication 8, dans lequel ledit support est un métal, un alliage, ou une céramique.
